Europäisches Patentamt

(19) European Patent Office

Office européen des brevets

(11) Veröffentlichungsnummer: **0 025 954**

**A1**

(12) **EUROPÄISCHE PATENTANMELDUNG**

(21) Anmeldenummer: **80105474.3**

(22) Anmeldetag: **12.09.80**

(51) Int. Cl.³: **F 16 C 32/04**
**G 01 R 11/14**

(30) Priorität: **25.09.79 DE 2938809**

(43) Veröffentlichungstag der Anmeldung:
**01.04.81 Patentblatt 81/13**

(84) Benannte Vertragsstaaten:
**AT CH FR GB IT LI SE**

(71) Anmelder: **SIEMENS AKTIENGESELLSCHAFT Berlin
und München
Postfach 22 02 61
D-8000 München 22(DE)**

(72) Erfinder: **Forster, Helmut
Forchheimer Strasse 27
D-8521 Neunkirchen(DE)**

(72) Erfinder: **Hini, Paul
Barschenweg 10
D-8520 Kosbach(DE)**

(72) Erfinder: **Stransky, Gerd
Burgstrasse 15a
D-8755 Alzenau(DE)**

(54) **Magnetisches Schwebelager.**

(57) Ein magnetisches Schwebelager für einen Rotationskörper (2) enthält in Achsrichtung hintereinander angeordnete
Magnetsysteme (12,16) aus koaxialen Dauermagneten
(10,11,14,15) mit flachem Querschnitt, die senkrecht zu ihren
Flachseiten magnetisiert sind und deren einander gegenüberstehende freie Polflächen jeweils einen Kegelstumpf bilden, der zu einem Kegel gehört, dessen Achse in der Rotationsachse liegt. Die Spitzen der Kegel der beiden Magnetsysteme (12,16) sind entgegengesetzt gerichtet. In diesem
Schwebelager bilden die Magnetsysteme (12, 16) zugleich
Haltekräfte und Führungskräfte für den Rotationskörper (2).

EP 0 025 954 A1

./...

Croydon Printing Company Ltd

SIEMENS AKTIENGESELLSCHAFT          Unser Zeichen
Berlin und München                  VPA **79 P 7 5 5 8** EUR

Magnetisches Schwebelager

Die Erfindung bezieht sich auf ein magnetisches Schwebelager für einen Rotationskörper mit in Achsrichtung
hintereinander angeordneten Magnetsystemen, die jeweils
zwei ringförmige, koaxial angeordnete Dauermagnete mit
abstoßender Polung enthalten, von denen jeweils einer
am Rotationskörper und der andere am Ständer befestigt
ist.

Bei magnetischen Lagern für stehende Wellen, beispielsweise für die Läuferwelle von Elektrizitätszählern,
wird das Gewicht der Wellen und des mit ihr verbundenen
Rotationskörpers durch Magnetfelder teilweise oder auch
ganz kompensiert. Im Falle einer teilweisen Kompensierung wird der Druck der Welle auf ein tragendes Lager
vermindert und im Falle der vollständigen Kompensierung
wird die Welle magnetisch in der Schwebe gehalten.

Eine bekannte Ausführungsform eines magnetischen Schwebelagers für eine stehende Welle enthält in Achsrich-

Kin 2 Koe / 27.8.1979

tung der Welle hintereinander angeordnete Magnetsysteme mit jeweils zwei koaxial zueinander angeordneten Magneten mit radialer Magnetisierung und abstoßender Polung. Die senkrecht zur Rotationsachse gerichteten abstoßenden Magnetkräfte bilden die Führungskräfte für den Rotationskörper. Zur Bildung von Haltekräften in Richtung der Rotationsachse sind besondere Stabilisierungssysteme erforderlich. Zur Stabilisierung dient das steuerbare Magnetfeld eines Elektromagneten, dessen Magnetfluß auf einen diamagnetischen Körper wirkt, der mit dem Rotationskörper verbunden ist (DE-AS 1 472 413).

Es ist ferner bekannt, ein elektromagnetisches Trag- und Führungssystem dadurch zu kombinieren, daß eine als Rückschlußkörper für einen Elektromagneten dienende Ankerschiene zur Waagerechten geneigt angeordnet wird. Durch diese Schrägstellung des Luftspalts erhält man eine Kraftrichtung, die sowohl eine als Haltekraft dienende Komponente in senkrechter Richtung als auch eine als Führungskraft dienende Komponente in waagrechter Richtung erzeugt. Wenn die Summe aller Führungskräfte Null ist, schwebt das bewegliche Systemteil innerhalb der ruhenden Anordnung. Mehrere Elektromagneten werden in der Bewegungsrichtung hintereinander angeordnet und die Neigung der Ankerschienen wird so gewählt, daß die einzelnen Magneten jeweils abwechselnd Führungskräfte in der einen und in der entgegengesetzten Richtung erzeugen. Von außen einwirkende Kräfte auf den Bewegungskörper werden kompensiert durch entsprechende Änderung der Führungskräfte. Zu diesem Zweck erhält das System eine empfindliche Regelung für die Elektromagneten (DE-AS 2 134 424).

Der Erfindung liegt nun die Aufgabe zugrunde, ein magnetisches Schwebelager der eingangs genannten Art zu vereinfachen und zu verbessern, insbesondere soll das magnetische Trag- und Führungssystem so kombiniert werden, daß der Rotationskörper sowohl in der Achsrichtung als auch senkrecht zur Achsrichtung ohne zusätzliche Stabilisierungssysteme stabil gelagert wird.

Diese Aufgabe wird erfindungsgemäß gelöst durch die kennzeichnenden Merkmale des Anspruchs 1. Die beiden Magnetsysteme bilden durch die geneigte Anordnung ihrer Polflächen magnetische Abstoßungskräfte, die sowohl Komponenten in der Achsrichtung als auch in radialer Richtung erzeugen. Der Rotationskörper wird im Ständer in der Schwebe gehalten, wenn die Summe der Tragkräfte und die Summe der Führungskräfte Null ist. Das Eigengewicht des Rotationskörpers kann dadurch berücksichtigt werden, daß die Luftspalte der beiden Magnetsysteme entsprechend unterschiedlich bemessen werden.

Durch die Neigung der Polflächen der beiden Magnetsysteme können bei konstanter Magnetkraft die Komponenten in senkrechter und waagrechter Richtung, d.h. die Trag- und Führungskräfte, geändert werden.

Unter Umständen kann es zweckmäßig sein, beispielsweise bei Rotationskörpern mit verhältnismäßig großem Gewicht oder zusätzlich in Richtung der Rotationsachse einwirkenden Kräften, ein oder mehrere zusätzliche Magnetsysteme konzentrisch zur Rotationsachse anzuordnen, deren Neigungswinkel der Polflächen so gewählt wird, daß entweder die Tragkräfte oder die Führungskräfte verstärkt werden.

Der Rotationskörper wird nahezu unabhängig von seiner Lage, d.h. sowohl mit senkrechter als auch mit waagrechter Anordnung, und unter Umständen auch mit geneigter Anordnung der Welle in seiner Schwebelage im Ständer gehalten.

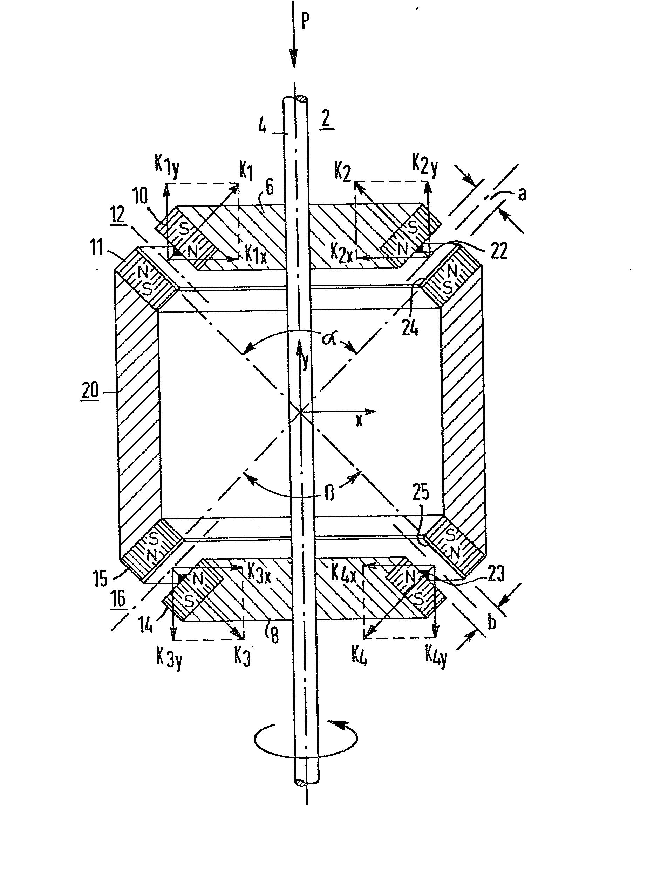

Zur weiteren Erläuterung der Erfindung wird auf die Zeichnung Bezug genommen, in der ein Ausführungsbeispiel eines magnetischen Schwebelagers nach der Erfindung als Schnittbild schematisch veranschaulicht ist.

In der Figur ist ein Rotationskörper mit 2 bezeichnet, der eine Welle 4 und zwei scheibenförmige Stützkörper 6 und 8 enthält, die jeweils als Träger für einen flachen ringförmigen Magneten 10 bzw. 14 dienen. Diese Magneten 10 und 14 bilden zusammen mit einem weiteren ebenfalls ringförmig und flach gestalteten Magneten 11 bzw. 15 jeweils ein Magnetsystem 12 bzw. 16. Die Magnete 10, 11 und 14, 15 sind in Richtung ihrer Dicke magnetisiert und so angeordnet, daß sich gleichnamige Pole gegenüberstehen und abstoßende Magnetkräfte erzeugt werden, was in der Figur durch die Pole N und S angedeutet ist. Die Magnete 11 und 15 sind an einem Ständer 20 befestigt, der als ruhendes Bauteil angenommen ist, obwohl die magnetischen Kräfte $K_1$ bis $K_4$ eine Relativbewegung des Rotationskörpers 2 gegenüber dem Ständer 20 zulassen. Es ist somit auch möglich, daß der Rotationskörper 2 in einer Ruhelage gehalten wird und daß sich dann der Ständer 20 in einer Schwebelage symmetrisch zur in der Figur nicht näher bezeichneten Rotationsachse hält, sofern das Eigengewicht des Ständers 20 unberücksichtigt bleibt und äußere Kräfte auf das System nicht einwirken.

Die Kraft $K_1$ hat eine Kraftkomponente $K_{1x}$ in waagrechter Richtung, die als Führungskraft dient und eine Kraftkomponente $K_{1y}$ in senkrechter Richtung, die als Tragkraft für den Rotationskörper 2 dient. In gleicher Weise kann die magnetische Kraft $K_2$ in ihre waagrechte Komponente $K_{2x}$ und ihre senkrechte Komponente $K_{2y}$ verlegt werden. Die beiden Kraftkomponenten $K_{1x}$ und $K_{2x}$ sind in waagerechter Richtung gegeneinander gerichtet und dienen als Führungskräfte für den Rotationskörper 2. Die magnetischen Kräfte $K_3$ und $K_4$ bilden jeweils eine senkrechte Komponente $K_{3y}$ bzw. $K_{4y}$, die den Kraftkomponenten $K_{1y}$ und $K_{2y}$ entgegengerichtet sind und ebenfalls als Haltekräfte für den Rotationskörper 2 dienen. Die waagerechten Komponenten $K_{3x}$ und $K_{4x}$ dienen als Führungskräfte. Der Rotationskörper 2 befindet sich in einer stabilen Schwebelage, wenn die Summe der Tragkräfte $K_{1y}$ bis $K_{4y}$ und die Summe der Führungskräfte $K_{1x}$ bis $K_{4x}$ Null ist.

Die einander gegenüberliegenden Polflächen der Magnete 10 und 11 bzw. 14 und 15 begrenzen jeweils einen Kegelstumpf, der zu einem Kegel gehört, dessen Achse in der Rotationsachse des Rotationskörpers 2 liegt. Diese beiden Kegel des oberen Magnetsystems 12 sind nach unten gerichtet, was in der Figur durch den Öffnungswinkel $\alpha$ angedeutet ist. Die beiden Kegel des unteren Magnetsystems 16 sind demgegenüber mit ihrer Spitze nach oben gerichtet, was in der Figur durch den Öffnungswinkel $\beta$ eines dieser Kegel angedeutet ist. Das magnetische Schwebelager würde den Rotationskörper 2 in gleicher Weise in einem Schwebezustand halten, wenn das obere Magnetsystem 12 mit dem unteren Magnetsystem 16 vertauscht würde, dann würde der Öffnungswinkel des oberen Kegels nach oben und des unteren Kegels nach unten zeigen und diese Kegel wären wieder entgegengesetzt gerichtet.

Mit dem Neigungswinkel der Polflächen wird nicht die Größe, aber die Richtung der magnetischen Kraft geändert und damit ändern sich auch die Komponenten in senkrechter und waagrechter Richtung. Mit einer geringen Neigung, d.h. mit einem größeren Öffnungswinkel $\alpha$, würden beispielsweise die senkrechten Kraftkomponenten $K_{1y}$ und $K_{2y}$ vergrößert und die waagrechten Komponenten $K_{1x}$ und $K_{2x}$ entsprechend vermindert. Mit dieser Anordnung des Magnetsystems 12 erhält man somit entsprechend erhöhte Haltekräfte. In entsprechender Weise würde man mit einer steileren Anordnung der Polflächen des Magnetsystems 12, d.h. mit einem kleineren Öffnungswinkel $\alpha$, eine entsprechende Vergrößerung der Führungskräfte $K_{1x}$ und $K_{2x}$ erhalten.

Wirkt beispielsweise auf den Rotationskörper 2 eine Kraft P in Richtung der Rotationsachse und berücksichtigt man auch noch das Eigengewicht, so wird sich der Rotationskörper 2 aus der in der Figur angenommenen Lage senkrecht nach unten bewegen. Die entsprechende Verminderung des Abstandes a zwischen den Polflächen des Magnetsystems 12 bewirkt eine entsprechende Erhöhung der magnetischen Kräfte $K_1$ und $K_2$. Die Kraftvergrößerung bewirkt eine entsprechende Vergrößerung der Kraftkomponenten $K_{1y}$ und $K_{2y}$, die als Gegenkräfte für die äußere Kraft P wirken. Zugleich wird der Abstand b zwischen den Polflächen des Magnetsystems 16 vergrößert, was eine entsprechende Verminderung der magnetischen Kräfte $K_3$ und $K_4$ mit entsprechender Verminderung der Tragkräfte $K_{3y}$ und $K_{4y}$ zur Folge hat. Der Rotationskörper wird somit durch die äußere Kraft P nur sehr wenig verlagert.

Unter Umständen kann es zweckmäßig sein, oberhalb oder unterhalb der Magnetsysteme 12 und 16 noch ein zusätzliches Magnetsystem vorzusehen, dessen Neigung der Magnete so gewählt wird, daß es entweder große senkrechte Tragkomponenten oder große waagerechte Führungskomponenten bewirkt. Dieses zusätzliche Magnetsystem dient somit entweder als Haltesystem oder als Führungssystem für den Rotationskörper 2.

In einer bevorzugten Ausführungsform des magnetischen Schwebelagers kann, falls die Einwirkung von stoßartigen Kräften P in Achsrichtung zu erwarten ist, die Absenkung des Rotationskörpers 2 gegen die y-Richtung dadurch begrenzt werden, daß im Luftspalt zwischen den Dauermagneten 10 und 11 bzw. 14 und 15 der Magnetsysteme 12 und 16 jeweils ein Abstandhalter 22 bzw. 23 vorgesehen ist. Als Abstandhalter 22 und 23 ist beispielsweise ein Profilring geeignet, der auf einer der Polflächen der beiden Magnete befestigt sein kann.

Die dem Abstandhalter 22 bzw. 23 gegenüberliegende Polfläche des anderen Magneten 11 bzw. 15 kann jeweils mit einer Abdeckung 24 bzw. 25 aus nichtmagnetischem Material, vorzugsweise einer Kunststoffolie, versehen sein, die als Gleitfläche und zugleich als Dämpfungskörper für eine stoßartige Auslenkung des Rotationskörpers 2 dient.

5 Patentansprüche
1 Figur

Patentansprüche

1. Magnetisches Schwebelager für einen Rotationskörper mit in Achsrichtung hintereinander angeordneten Magnetsystemen, die jeweils zwei ringförmige, koaxial angeordnete Dauermagneten mit abstoßender Polung enthalten, von denen jeweils einer am Rotationskörper und der andere am Ständer befestigt ist, d a d u r c h g e k e n n z e i c h n e t , daß Dauermagnete (10, 11, 14, 15) mit flachem Querschnitt vorgesehen sind, die senkrecht zu ihren Flachseiten magnetisiert sind und deren einander gegenüberstehende freie Polflächen jeweils einen Kegelstumpf bilden, der zu einem Kegel gehört, dessen Achse in der Rotationsachse liegt, und daß die Spitzen der Kegel der beiden Magnetsysteme (12, 16) entgegengesetzt gerichtet sind.

2. Schwebelager nach Anspruch 1, d a d u r c h g e k e n n z e i c h n e t , daß die Neigung der Polflächen der Magnete (10, 11) des einen Magnetsystems (12) vom Neigungswinkel der Polflächen der Magnete (14, 15) des anderen Magnetsystems (16) abweicht.

3. Schwebelager nach Anspruch 1 oder 2, d a d u r c h g e k e n n z e i c h n e t , daß zusätzliche Magnetsysteme vorgesehen sind.

4. Schwebelager nach einem der Ansprüche 1 bis 3, d a d u r c h g e k e n n z e i c h n e t , daß im Luftspalt der Magnetsysteme (12 und 16) jeweils ein Abstandhalter (22 bzw. 23) aus nichtmagnetischem Material vorgesehen ist.

5. Schwebelager nach Anspruch 4, d a d u r c h
g e k e n n z e i c h n e t ,  daß der Abstandhalter
(22, 23) jeweils auf einer der beiden Polflächen der
Magnete des Magnetsystems (12 bzw. 16) angeordnet ist
und die andere Polfläche mit einer Abdeckung (24, 25)
aus nichtmagnetischem Material versehen ist.

# EUROPÄISCHER RECHERCHENBERICHT

EP 80 10 5474.3

| Kategorie | Kennzeichnung des Dokuments mit Angabe, soweit erforderlich, der maßgeblichen Teile | betrifft Anspruch |
|---|---|---|
| | **EINSCHLÄGIGE DOKUMENTE** | |
| X | DE - A - 2 136 371 (K. BRAUN)<br>* Ansprüche 1, 12; Fig. 4, 5 *<br>-- | 1 |
| X | FR - A1 - 2 367 939 (B. GATTEGNO)<br>* Ansprüche 1, 3, 4; Fig. 1, 2, 4 *<br>-- | 1-3 |
| X | FR - A - 1 317 962 (G. BERNARD)<br>* Fig. 1, 2 *<br>-- | 1 |
| | US - A - 2 436 939 (H.L. SCHUG)<br>* Fig. 1, Position 16, Fig. 3 *<br>-- | 1,4,5 |
| | US - A - 2 856 239 (E.N. DACUS)<br>* Fig. 1, 2 *<br>-- | 4,5 |
| A | CH - A - 269 545 (LANDIS & GYR AG)<br>* gesamtes Dokument *<br>-- | |
| A | CH - A - 290 032 (SIEMENS-SCHUCKERT-WERKE AG)<br>* gesamtes Dokument *<br>-- | |
| A | CH - A - 290 344 (SIEMENS-SCHUCKERT-WERKE AG)<br>* gesamtes Dokument *<br>-- | |
| D,A | DE - A - 1 472 413 (SIEMENS AG)<br>* gesamtes Dokument *<br>-- | |
| | ./.. | |

**KLASSIFIKATION DER ANMELDUNG (Int.Cl.3)**

F 16 C 32/04

G 01 R 11/14

**RECHERCHIERTE SACHGEBIETE (Int. Cl.3)**

F 16 C 32/00

F 16 C 39/00

G 01 R 11/00

H 02 K 5/00

H 02 K 7/00

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Berlin | 18-11-1980 | MASSALSKI |

EPA form 1503.1 06.78

Europäisches
Patentamt

**EUROPÄISCHER RECHERCHENBERICHT**

| | EINSCHLÄGIGE DOKUMENTE | | KLASSIFIKATION DER ANMELDUNG (Int.Cl.³) |
|---|---|---|---|
| Kategorie | Kennzeichnung des Dokuments mit Angabe, soweit erforderlich, der maßgeblichen Teile | betrifft Anspruch | |
| D,A | <u>DE - B - 2 134 424</u> (KRAUSS-MAFFEI AG)<br><br>* gesamtes Dokument *<br><br>---- | | |
| | | | RECHERCHIERTE SACHGEBIETE (Int. Cl.³) |